# EUROPEAN PATENT APPLICATION

(11) **EP 3 770 728 A1**
(43) Date of publication of application: **27.01.2021**
(21) Application number: 19188575.5
(22) Date of filing: 26.07.2019
(51) Int. Cl.: G06F 3/01, H03K 17/96

(54) **THIN-FILM-BASED TRIBOELECTRIC ACTUATOR**

(71) Applicant: SABIC Global Technologies B.V., 4612 PX Bergen op Zoom (NL)
(72) Inventor: SAS, Martin, 4612 PX Bergen op Zoom (NL); TAYEB, Mohammed A., 23955-6900 Thuwal (SA); OWENS, III, Donald E., 23955-6900 Thuwal (SA); NAYAK, Pradipta K., 23955-6900 Thuwal (SA); ALSALEM, Fahad Khalid, 23955-6900 Thuwal (SA)
(74) Representative: Elzaburu S.L.P.

(57) **Abstract**

A triboelectric device, system, and related methods are disclosed. An example device can comprise an electrode and a triboelectric layer coupled to the electrode. The triboelectric layer can be configured to receive, from a signal source and via the electrode, a signal to cause a change in an electrostatic potential of the triboelectric layer.

## Description

### Technical Field

The disclosure generally relates to thin films, and more particularly to thin-film devices comprising thermoplastic compositions that use the triboelectric effect to cause electrical and mechanical actuation, known as triboelectric actuators.

### Background

Surface micro-geometry, structure, and electrically induced tactile cognitive perception are not well-explored and studied fields. Although textural information can be obtained visually and processed with support of abstract logic, physical touch contact with a texture can yield finer and more informative perception of the texture. A human can distinguish textures, whose sizes and spatial periods differ by hundreds of nanometers, but there is not any known device that can detect the same level of detail or mimic this tactile experience with such precision. If a human runs his/her fingers across a surface, surface information can be perceived, such as roughness, smoothness, hardness, softness, stickiness, and slipperiness. Additionally, the human finger can perceive extreme information, such as thermally isolating or conductive materials. Overall, such tactile texture perception can play a significant role in the tactile recognition of an object's materials, texture, and natural shape. If a finger is moved across a texture, small vibrations are produced in the skin, which reflect the surface information. Yet there is no simple structured and precise device that is able to cause or detect the sensation of touch, texture, location, and morphology with human like resolution and accuracy.

Technologies existing for touch sensation include infrared, resistive, and capacitive devices, but these technologies have limitations. Infrared technology can be complex requiring both an infrared source and a media. Resistive touch sensors can have limitations that prevent them from implementing multi-touch functionality. Capacitive touch sensors can require complex active power electronics. Despite these different technologies, controllable surfaces interaction and haptic feedback is currently not a domain of flexible plastics solutions, such as triboelectric based devices. Triboelectricity has been considered mainly for attracting particles in the field of printing. Thus, there is a need for improved touch devices.

### Summary

As described herein, the disclosure includes novel devices that can simulate human textual perception as well as cause a human to perceive texture, feedback, or other surface information. An example device can comprise a triboelectric layer coupled to an electrode. Unlike conventional devices, a signal can be supplied to the triboelectric layer to cause feedback, such as electrical feedback, that is perceptible (e.g., as a texture, as a haptic feedback) by a human. The triboelectric layer can comprise a thin-film layer allowing fabrication of the device according to a variety of sizes for integration into different applications.

Additional advantages will be set forth in part in the description which follows or can be learned by practice. It is to be understood that both the foregoing general description and the following detailed description are exemplary and explanatory only and are not restrictive.

### Brief Description of the Drawings

The above-mentioned and other features and advantages of this disclosure, and the manner of attaining them, will become apparent and be better understood by reference to the following description of one aspect of the disclosure in conjunction with the accompanying drawings, wherein:
Figure 1 is a diagram showing an example device in accordance with the present disclosure.
Figure 2 is a diagram showing another example device with surface patterning.
Figure 3 is a diagram showing using a signal to cause sensation in a finger touching the disclosed device.
Figure 4 is a diagram showing an example circuit configuration of a device according to the disclosure.
Figure 5 is an image showing an example device fabricated in accordance with the present disclosure.
Figure 6 is a diagram showing a plan for another example device having a plurality of electrodes.
Figure 7 is an image showing another example device fabricated in accordance with the present disclosure.
Figure 8 shows an optical image of a triboelectric device for illustrating generating a sensation of movement along the device.
Figure 9 is a graph showing generation of a sensation of movement along the device.
Figure 10 is a block diagram illustrating an example computing device for implementing one or more aspects of the disclosure.

### Detailed Description

A device, methods, and systems based on triboelectric principles are disclosed. An example device can comprise a triboelectric effect actuator. Contact and/or friction of two materials with different electro-potential affinity can be used create controlled surface discharge from the triboelectric material layer into interacting object. This surface charge polarization of controlled electrostatic effect can cause attraction or repulsion of particles and/or surfaces with same or opposite surface charge. A signal (e.g., alternating signal) can be applied to a triboelectric layer to cause interaction (e.g., mechanical interaction, electrical interaction) with an object (e.g., touching or proximate to the triboelectric layer) based on a controlled electrostatic discharge. Applying a signal to cause an interaction can be referred to as actuation. The actuation can be perceived by a person as haptic feedback, tactile perception of a texture, and/or other similar sensations. The signal can comprise a variable duty cycle, a modulating amplitude, frequency, and/or the like. Surface patterning of the triboelectric material can be used to increase the strength of the actuation. The triboelectric layer can also be used for sensing. The sensing and the actuation can be implemented via the same triboelectric material and/or layer. The combination of sensing and actuating can be used to create a feedback control system (e.g., which can be used for safety features, such as haptic/tactile warnings for sensed events). The triboelectric material can comprise a blend of photoactive polycarbonate thermoplastic material (XPC) and Isofluoropropyl polyhedral oligomeric silsesquioxane (F-POSS), and/or other triboelectric material as described herein. The device can be used as a frequency generator/transmitter, oscillator, self-cleaning surfaces, and haptic feedback, and/or other applications.

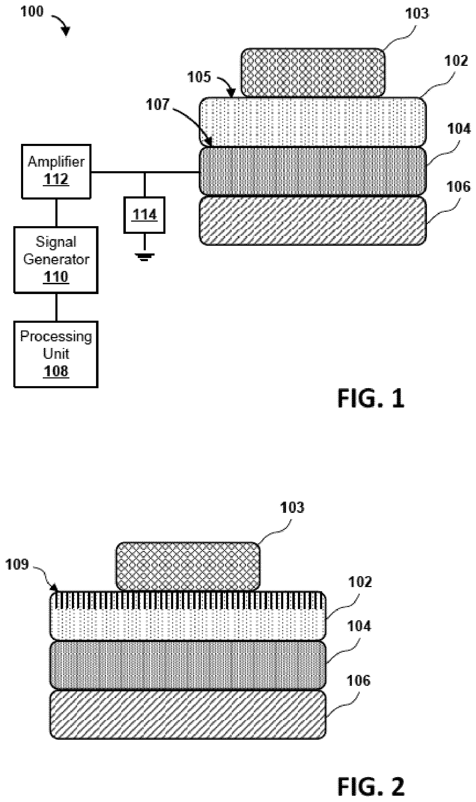

FIG. 1 is a diagram showing an example device 100 in accordance with the present disclosures. The device 100 can comprise an actuator, such as an actuator that relies on the triboelectric effect.

The device 100 can comprise a triboelectric layer 102. The triboelectric layer 102 can comprise a thin-film layer. A thin-film layer (e.g., or the triboelectric layer 102) can be a monolayer. The thin-film layer (e.g., or the triboelectric layer 102) can have a thickness of within a range of from about a nanometer to about several micrometers (e.g., or about several hundred micrometers). The thin-film layer (e.g., triboelectric layer 102) can have a thickness of about 1 µm to about 500 µm, about 1 µm to about 300 µm, or 1 µm to about 200 µm. The thickness of the thin-film layer can depend on end application needs, power consumption design (e.g., low power battery driven), a combination thereof, and/or the like.

The triboelectric layer 102 can output a signal based on a triboelectric effect. The triboelectric layer 102 can be caused to move mechanically, alter an electrical property, and/or the like in response to receiving a signal at the triboelectric layer 102. The triboelectric layer 102 can be configured to output a current signal in response to an interaction (e.g., mechanical contact, moving into proximity) with an object 103. The triboelectric layer 102 can be configured to electrically and/or mechanically apply a force to the object 103 in response to a signal supplied to the triboelectric layer 102. The triboelectric layer 102 can comprise a triboelectric material. The triboelectric material can comprise a polymer. The triboelectric material can comprise a triboelectric negative layer. The triboelectric material can comprise a triboelectric positive layer. Though only one triboelectric layer 102 is shown, it should be understood that in some implementations multiple triboelectric layers (e.g., stacked on top of triboelectric layer 102 or otherwise adjacent to) can be used.

The triboelectric material can comprise one or more of photoactive polycarbonate thermoplastic material (XPC) or isofluoropropyl polyhedral oligomeric silsesquioxane (F-POSS). The triboelectric material can comprise photoactive polycarbonate thermoplastic and isofluoropropyl polyhedral oligomeric silsesquioxane (XPC-F-POSS). XPC-F-POSS can comprise a polycarbonate polymer (e.g., XPC) with about 3.5% weight of benzophenone moieties in the polymer chain. The triboelectric material can comprise Polyvinylidene fluoride (PVDF), Polyvinyl chloride (PVC), polytetrafluoroethene (PTFE) (e.g., Teflon™), Polyvinylidene fluoride trifluoroethylene (PVDF-TrFE), a combination thereof, and/or the like.

XPC is a photoactive cross-linkable polycarbonate resin that includes about 0.5 mole % to about 5 mole % endcap groups derived from the monohydroxybenzophenone, including from about 1 mole % to about 3 mole, or from about 1.7 mole % to about 2.5 mole %, or from about 2 mole % to about 2.5 mole %, or from about 2.5 mole % to about 3.0 mole %, or from about 3.5 mole % to about 4.0 mole % endcap groups derived from the monohydroxybenzophenone. Most desirably, the monohydroxybenzophenone is 4-hydroxybenzophenone. In a particular aspect the resin includes about 3.5 mole % endcap groups derived from 4-hydroxybenzophenone, as shown in formula (1) below:

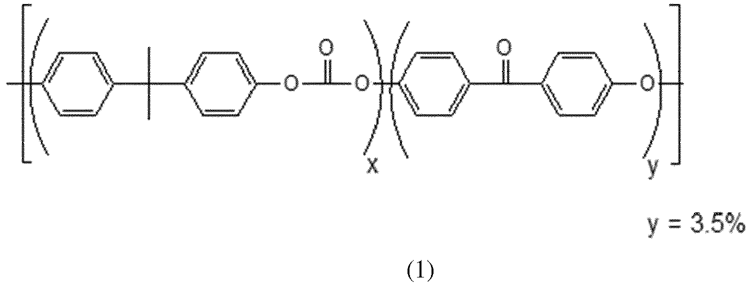

XPC may be formed in accordance with the methods described in U.S. Patent Publication No. 2017/0247507, the disclosure of which is incorporated herein by this reference in its entirety.

F-POSS is isofluoropropyl polyhedral oligomeric silsesquioxane, and has the chemical structure shown in formula (2):

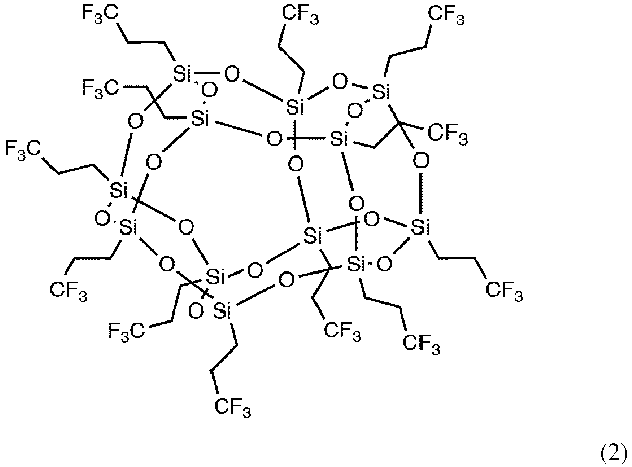

The triboelectric material can comprise photoactive polycarbonate isofluoropropyl polyhedral oligomeric silsesquioxane (XPC-F-POSS), polyvinylidene difluoride (PVDF), polydimethylsiloxane (PDMS), poly(methyl methacrylate) (PMMA), polytetrafluoroethylene (PTFE), polymer foams, poly(methyl methacrylate)-co-poly(1H-1H-perfluoroctyl methacrylate), acetate, mica, nylon, perfluorinated polymers, copolymers of the described polymers, and combinations thereof. The triboelectric material can comprise Polyvinyl chloride (PVC), polytetrafluoroethene (PTFE) (e.g., Teflon™), Polyvinylidene chloride (PVDC), polycarbonate (PC), functionalized PC, Polyvinylidene difluoride trifluoroethylene (PVDF-TrFE), a combination thereof, and/or the like.

The triboelectric layer 102 can comprise a first side 105. The triboelectric layer 102 can comprise a second side 107. The second side 107 can be opposite the first side 102. The first side 105 can receive the interaction (e.g., physical or electrical force) with the object 103. The object 103 can comprise an extremity (e.g., a finger), a surface, and/or a physical object. The first side 105 can receive contact with the object 103. The contact can comprise a touch event, placing the object 103 on the first side 105, moving the first side 105 to come in contact with the object 103, and/or the like. In some implementations, the first side 105 can comprise a surface patterning 109, as shown in FIG. 2. The surface patterning 109 can enhance (e.g., increase) the contact surface area and/or the friction coefficient of the triboelectric layer 102. Example sensor structures and effects of the surface patterning can be found in International Publication No. WO 2018002752 A1 filed on June 12, 2017, which is hereby incorporated by reference in its entirety.

The device 100 can comprise an electrode 104 disposed adjacent the triboelectric layer 102. As used herein, the term adjacent when used in relation to a layer can comprise next to, in contact with, above, on top of, below, coupled to, or a combination thereof. The term adjacent can allow for one or more intervening layers between two layers that are adjacent. The electrode 104 can be in contact with a second side 107 of the triboelectric layer 107. The electrode 104 can comprise a thin-film layer. The electrode 104 can comprise a conductive material, such as a metal. The electrode 104 can comprise titanium, gold, a combination thereof, and/or the like.

The device 100 can comprise a substrate 106 disposed adjacent the triboelectric layer 102, the electrode 104, or a combination thereof. The substrate 106 can be optional. The electrode 104 can be disposed on top of (e.g., in contact with) the substrate 106. The substrate 106 can comprise a rigid or flexible material. The substrate 106 can comprise a thin-film layer. The substrate 106 can comprise a polymer, such as polyimide, and silicon comprising a layer of polyimide. The substrate 106 can comprise Polyetherimide, Polyethylene naphthalate (PEN), Polyethylene terephthalate (PET), Polycarbonate, one or more thin sheets of metal, and/or a combination thereof. An example rigid material can comprise an indium tin oxide (ITO) coated glass.

The device 100 can comprise a processing unit 108. The processing unit 108 can comprise a computer processor, a microcontroller, a field programmable gate array, a plurality of logic gates, an integrated circuit, a combination thereof, and/or the like. The processing unit 108 can be electrically coupled (e.g., via at least the electrode 104) to the triboelectric layer 102. The processing unit 108 can be implemented as one or more thin-film layers. The processing unit 108 can comprise a thin-film processor.

The device 100 can comprise a signal generator 110. The signal generator 110 can comprise a modulator configured to generate electrical signals. The signal generator 110 can comprise an integrated circuit, a chip, and/or circuitry adjacent to an integrated circuit, and/or the like. The signal generator 110 can comprise a digital signal controller. The signal generator 110 can comprise any device configured to generate signals based on digital signal processing. The signal generator 110 can comprise an integrated circuit configured for controlling (e.g., digitally controlling) a power supply, modulator, and/or the like.

The signal generator 110 can be configured to generate a plurality of signals. The plurality of signals can be amplitude modulated signals, frequency modulated signals, and/or the like. The plurality of signals can comprise square waves, sinusoidal waves, triangle waves, pulse waves, sawtooth waves, a combination thereof, and/or the like. The plurality of signals can cause an effect upon the object 103. The plurality of signals can provide feedback (e.g., haptic feedback) to the object. 103. The plurality of signals can repel the object 103 (e.g., to provide self cleaning). The plurality of signals can attract the object 103 (e.g., for cleaning, applying paint, charge mitigation, protecting sensitive electronics, optics applications, etc.). The plurality of signals can cause the triboelectric layer 102 to vibrate, thereby causing air pressure waves (e.g., to generate a sound infrasound, ultra sound, etc). The plurality of signals can translate an electrical frequency into a mechanical vibration.

A signal can comprise an alternating waveform with modulation of one or more of frequency or amplitude (e.g., power). The signal can be a modulated (e.g., amplitude or frequency) sign wave, square wave, triangle wave, trapezoid wave, or a combination thereof. The signal can comprise any combination (e.g., addition, subtraction, multiplication, division, or other mathematical operation) of sign wave, square wave, triangle wave, trapezoid wave. The signal can be generated based on software, an algorithm, a function, a computer readable instruction, and/or the like programmed in digital signal controller.

The processing unit 108 can be configured to control the signal generator 110. The processing unit 108 can comprise a programmable processor or controller (e.g., a microcontroller such as Arduino). The processing unit 108 can comprise a microcontroller, a digital signal controller, and/or the like. In some implementations, a processing unit 108 can be a simple set of circuit elements, such as one or more transistors (e.g., power or radio frequency transistors). Other devices, such as analog power management devices, an RC oscillator, a crystal oscillator (e.g., a clock with a specific frequency), and/or the like can be used to cause generation of signals. A program can be loaded into the processing unit 108 (e.g., processor/controller). The program can comprise instructions for configuring the processing unit 108 to determine a signal to be generated by the signal generator 110. The processing unit 108 can be configured to control the signal generator 110 to generate the plurality of signals. The processing unit 108 can be configured to control the signal generator 110 to generate the plurality of signals based on data received by the processing unit 108. The data received by the processing unit 108 can comprise data determined by the processing unit 108. The processing unit 108 can comprise one or more rules for determining the data based on conditions, states, sensor data, and/or other information.

The data received by the processing unit 108 can comprise data received by another device (e.g., which is part of the same system or is an external device). The data can be received via a network (e.g., wireless network, local area network, wide area network). In some implementations, the processing unit 108 can be configured to control the signal generator 110 based on signals received from a triboelectric layer (e.g., the triboelectric layer 102, or a different triboelectric layer) as described in more detail herein.

The processing unit 108 can be configured to control the signal generator 110 based on signals received from the electrode 104. The processing unit 108 can be configured to control the signal generator 110 based on signals received from an additional electrode. The additional electrode can be an additional electrode in contact with the triboelectric layer 102. The additional electrode can be in contact with a different triboelectric layer than the triboelectric layer 102 shown. For example, a system can include a triboelectric layer configured as a sensor. The system can include another a triboelectric layer configured as an actuator. The system can adaptively change which triboelectric layer is used as an actuator and which triboelectric layer is used as a sensor (e.g., based on which devices in the system detect touch events, or based on logic implemented by the processing unit 108). The processor 108 can determine, based on a received signal (e.g., from a sensor such as a triboelectric sensor or other sensor), one or more data values (e.g., or metrics), such as the occurrence of a contact event, the force of the contact event, a beginning of a contact event, an end of a contact event, and/or the time length of the contact event. The processing unit 108 can store a history of data values. The processing unit 108 can apply the one or more rules to determine a signal to generate based on the data values, the history of the data values, trends in the data values, comparison of the data values to thresholds (e.g., or states), a combination thereof, and/or the like.

The device 100 can comprise an amplifier 112 (e.g., or other gain medium). The amplifier 112 can be configured to receive the plurality of signals from the signal generator 110. The amplifier 112 can be configured to amplify one or more of the plurality of signals. The amplifier 112 can be configured to amplify the input of an AC voltage at one or more frequencies. The amplifier 112 can comprise an operational amplifier (op amp). The device 100 can comprise a load 114. The load 114 can comprise a resistor, a transistor, a combination thereof, and/or the like. The load 114 can be configured to cause signal filtering, such as high pass filtering, low pass filtering, RCL filtering (e.g., capacitor or inductor filtering), a combination thereof, and/or the like. The load 114 can be electrically coupled in parallel with the triboelectric layer 102 (e.g., from the amplifier 112). The load 114 can be electrically coupled to ground. The load 114 can be electrically coupled to the amplifier 112 and/or the triboelectric layer 102.

The device 100 (e.g., or sensor) can be integrated into a variety of devices, systems, and other applications. The device 100 can be used to provide haptic feedback (e.g., for a wearable device, mobile device, smart device). The device 100 can be comprised in a robotic hand, an electronic skin, and/or the like. The device 100 can be used as a self-cleaning surface (e.g., in a wall for painting, in an electronic device). The device 100 can be used as an electro-mechanical structure to generate vibrations, sound waves. The device 100 can be used to simulate textures.

Additional details regarding the device 100 are described as follows. The device 100 can comprise a polymeric based thin and flexible spatial electrostatic touch and surface mapping sensor/actuator for touch detection and surface information revealing applications. The device 100 can comprise a patterned conductive layer (e.g., electrode 104) in conjunction with triboelectric materials to provide the ability to detect the touch, location and probably surface structure to some degrees. The electrode 104 can be made of any conductive and/or semi conductive materials. The electrode 104 can be designed according to any shape or 2D geometry. The triboelectric layer 102 can be made of any triboelectric materials, such as PVDF, PVDF-TrFE, XPC-FPOSS, PTFE, or a combination thereof.

The device can be implemented as actuator, which can be is used in a mobile phone, robotics' body, by disabled or blind human, in electronic skin, and/or the like. The device 100 can be used in any application in which a surface morphology, touch, and/or location are of importance (e.g., virtual reality, augmented reality, tactile safety warnings features, ATMs, etc.). The actuator can be made transparent, for example, by the use of ITO as the electrode and XPC-FPOSS as the triboelectric layer. The actuator can be made opaque by the use of Ti, Au, Ag, and/or the like as the electrode.

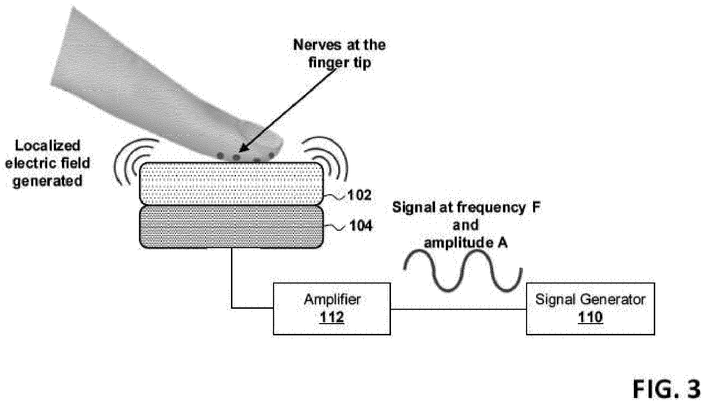

As shown in FIG. 3, the disclosed device can be configured to create the sensation of touch/actuation by exciting nerves in an extremity, such as a finger, a limb, skin, and/or the like. The nerves can be excited by generating an electric field at the triboelectric layer 102. The electric field can have a certain frequency, waveform, and amplitude that is perceptible to the nerves of the finger tip. The signal generator 110 can generate the signal that causes the electric field. An amplifier 112 can amplify the signal and provide the signal to the electrode 104. The electrode 104 can cause an electric field to be generated in the triboelectric layer 102. The electric field can be generated in the triboelectric layer 102 without causing any vibration, mechanical effect, or sound in the triboelectric layer 102. A rigid or flexible layer can be added to provide mechanical support.

The triboelectric layer 102 can be the top most surface of the device 102 (e.g., or a sensor portion of the device 100). The triboelectric layer 102 can comprise a first material having a tendency to donate electrons while an object in contact with the triboelectric layer can comprise a second material having a tendency to capture those electrons, where the object to be tested could donate or capture electrons. In some scenarios, a first triboelectric layer can have a negative electro-affinity and a second triboelectric layer can have a positive electro-affinity. Objects of different electro-affinities can be sensed using either one of the first triboelectric layer or the second triboelectric layer. By placing in contact materials having different triboelectric properties (e.g., electro affinities), a transfer of charges is created between those materials which can be reflected in the form of voltage differential or current flow. The current response in the device 100 can be proportional to the difference of electro-affinity between contact surfaces. The working principle of the device can be based on the charges generated based on the triboelectric layer 102 being in contact with a material having an opposite or varying electro-affinity. Both voltage and current outputs can be used by the device. Voltage response (e.g., measured in the open circuit condition) can be used to identify the touch event. Current response (e.g., measured in the short circuit condition) can be used to determine other characteristics of a touch event.

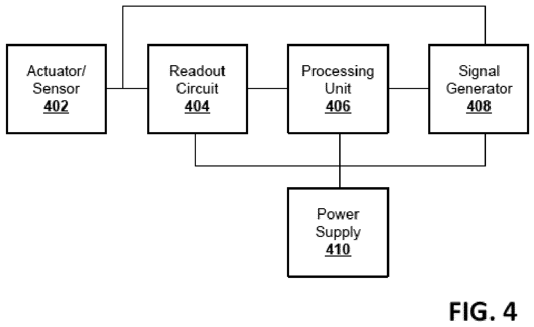

FIG. 4 is a diagram showing an example circuit configuration of a device according to the disclosure. An example device (e.g., or system) in accordance with the present disclosure can comprise an actuator/sensor 402, a readout circuit 404, a processing unit 406, a signal generator 408, a power supply 410, a combination thereof, and/or the like.

The example device can switch between two operating states (e.g., actuating and sensing). The example device can switch between the two operating states by reversing and/or alternating the power flow direction (e.g., to or from the actuator/sensor 402). If operating as an actuator, power can be supplied to the actuator/sensor 402 from the power supply 410. If operating as a sensor, the power supply 410 can be uncoupled (e.g., disconnected, switched off) from the actuator/sensor 402. If operating as a sensor, the readout circuit 404 can detect (e.g., or sense) a voltage drop generated based on the triboelectric effect on the surface of a triboelectric layer.

The actuator/sensor 402 can comprise one or more of the triboelectric layer 102, the electrode 104, or the substrate 108. The power supply 410 can be electrically connected to (e.g., and provided power to) one or more of the readout circuit 404, the processing unit 406, the signal generator 408. The power supply 410 may not be electrically connected to the actuator/sensor 402. The readout circuit 404 can be configured to convert a signal and/or change in state of the actuator/sensor 402 to a current signal and/or voltage signal. The readout circuit 404 can be configured to condition (e.g., amplify) a signal received from the actuator/sensor 404 and supply one or more signals to the processing unit 406.

The processing unit 406 can be configured to cause the signal generator 408 to supply one or more signals to the actuator/sensor 402. The actuator/sensor 402 can function as an actuator if the one or more signals are supplied to the actuator/sensor 402. The one or more signals can have an amplitude, frequency, and/or other characteristic selected by the processing unit 406. Data indicative of different signals having different amplitude, frequency, and/or other characteristic can be stored and/or associated with corresponding conditions (e.g., state, trigger, logic result). For example, a square wave with a first frequency and/or first amplitude can be associated with a first type of haptic feedback. A square wave with a second frequency and/or second amplitude can be associated with a second type of haptic feedback.

The actuator/sensor 402 can function as a sensor by supplying signals upon receiving contact with object. The processing unit 406 can be configured to analyze the one or more signals received and determine one or more conditions, such as the occurrence of contact with the actuator/sensor 402, a characteristic of the object (e.g., material, size, geometry, electrical properties) contacting the actuator/sensor 402, an amount of force (e.g., or pressure) of the contact, a duration of the contact, a combination thereof, and/or the like. The processing unit 406 can store the one or more conditions in memory (e.g., not shown). The processing unit 406 can output (e.g., display, send, transmit) the one or more conditions. For example, the occurrence of contact with the material detector 402, a type of material that contacted the material detector 402, an amount of force (e.g., or pressure) of the contact, a combination thereof, and/or the like can be caused to be output by the processing unit 406.

The processing unit 406 can be configured to determine an occurrence of a touch event based on a voltage signal. A change in the voltage signal, such as a voltage peak can be used to determine that a touch event occurred. The voltage signal having an amplitude above a threshold can be used to determine a touch event occurred. Various voltage thresholds can be associated with corresponding force levels. The force of a contact event can be determined by matching the voltage with a corresponding force level. The time length can be determined based on a time associated with a beginning of detecting the voltage signal and a time associated with an end of detecting the voltage signal. The processing unit 406 can be configured to determine, based on the current signal, a characteristic of the object. The processing unit 406 can be configured to determine the material of the object based on determining that the current signal has a signal characteristic associated with the characteristic. The processing unit 406 (e.g., or the readout circuit 404) can convert the current value to a voltage value. The voltage value can represent the current characteristic, current level, and/or the like. The voltage value can be used to determine the characteristic of the object.

The readout circuit 404 can be implemented as one or more thin-film layers. In some implementations, the readout circuit 404 can be comprised in the processing unit 406. The readout circuit 404 can be electrically coupled an electrode of the actuator/sensor 402. The readout circuit 404 can be electrically coupled between the actuator/sensor 402 and the processing unit 406. The readout circuit 404 can be configured to receive a current signal from the actuator/sensor 402 (e.g., from triboelectric layer 102, via the electrode 104). The current signal can be generated by the actuator/sensor 402 in response to an interaction. The readout circuit 404 can be configured to generate a voltage signal based on the current signal. The readout circuit 404 can supply the current signal, the voltage signal, electrical charge, or a combination thereof

The readout circuit 404 can comprise an active readout circuit, a passive readout circuit, and/or the like. The readout circuit 404 can be configured to generate signals readable by the processing unit 406 based on changes in a current signal (e.g., that can be too small for the processing unit 406 to detect) from the actuator/sensor 402. The readout circuit 404 can comprise one or more circuit components, such as a load element, a resistor, a transistor, a buffer element, an inverter, a differential amplifier, a charge sense amplifier, as switch, a capacitor, a combination thereof, and/or the like.

It should be appreciated that the devices and sensors disclosed herein can comprise any of the following features: use of XPC-F-POSS as active triboelectric matrix as sensor/actuator, use of fluorinated polymers (such as PVDF) as sensor/actuator, use of triboelectric materials (such as PVC, PVDC, etc.) for sensing contact and features of the contact, all thin-film sensor and/or actuator, ability to detect touch and object characteristics in contact using the same device, single electrode configuration of the TE-based sensor with a simple architecture and ease of fabrication, multiple electrode configuration, mechanically flexible and bendable sensor/actuator, optically transparent material (e.g., using XPC-F-POSS), translucent material, opaque material, and/or the like. The device and/or sensor disclosed herein can be built using microfabrication techniques, inkjet printing, molding, extrusion, etc. The device and/or sensor disclosed herein can be integrated into 3D structures and surfaces. The device and/or sensor disclosed herein can be inexpensive and simple to manufacture/fabricate/scale up. The features and other can be implemented as an improvement over conventional sensors.

### Examples

In this section, description of the fabrication and characterization of the designed triboelectric devices are disclosed. Though the following is illustrated using example values, processes, and materials, it is contemplated that other materials, processes, and values can be used according to design specifications.

### Example 1

A first example device was fabricated with a triboelectric layer comprising XPC-FPOSS. The triboelectric layer was coated on an copper electrode. An AC signal with voltage of 70V to 80V and low frequencies of 1Hz to 5Hz was supplied to the device. These conditions provided hepatic feedback in form of electrical pulses perceived via human finger.

A flexible substrate of PEN and/or ULTEM was used as a carrier. After cleaning with DI and blowing with N2 to remove any particles or contaminants, e-beam deposition was used to deposit an electrode. The electrode included a titanium (Ti) layer of about 30 nm thickness to act as adhesive layer. The electrode included a gold (Au) layer of around 70 nm thickness to act as the conductive layer. In certain circumstances, a predesigned and fabricated shadow mask was used to induce special designed electrodes. An active triboelectric layer was finally spin coated on top of the electrode layer and cured/annealed. In some examples, an extruded film was used, instead.

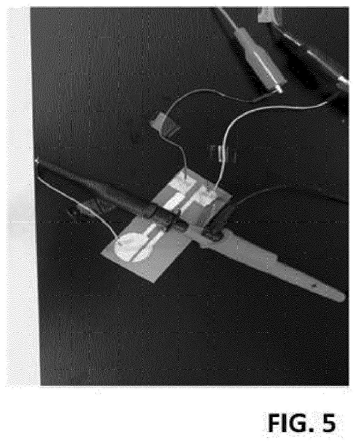

A waveform generator was selected to set at a frequency range from Hz to MHz and the intended waveform. The waveform generator was connected to signal amplifier to amplify the input of AC voltage at specific frequency. At the surface of the triboelectric layer, the electric field was induced to interact and excite touching human nerves or counter material. A dual electrode was fabricated in order to have the human body acts as the reference potential point, as shown in FIG. 5.

There are several ways to quantify the human sensation including the use of a voltmeter to measure the surface voltage, to calculate the waveform root mean square (RMS) that is a term related to peak-to-peak amplitudes for any continuous periodic wave - time averaged power delivered is equivalent to the power delivered by a DC voltage, or to implement the human body electrical model (HBM) used for ESD evaluation, as shown below in Table 1.

**Table 1.**

| **HBM-Human body electrical model** | |
|---|---|
| Skin contact resistance [Ω] | 100000 |
| Internal body resistance [Ω] | 300 |
| Wet body resistance [Ω] | 400 |
| Skin breakdown voltage [V] | 500 |
| Body capacitance [pF] | 100 |

Experiments were performed for a variety of different wave forms, voltages, frequencies, and triboelectric layer thickness. The experimental testing data is shown below in Table 2.

**Table 2.**

| **Waveform** | **Voltage (V)** | **Frequency** | **Sensation (Yes/No)** | **Active layer thickness** |
|---|---|---|---|---|
| Sine | 60 | 1 kHz | N | < 20 Mµ |
| Sine | 100 | 100 kHz | N | < 20 Mµ |
| Sine | 180 | 200 kHz | N | < 20 Mµ |
| Square | 60 | 10 kHz | N | < 20 Mµ |
| Square | 100 | 10 kHz | N | < 20 Mµ |
| Square | 100 | 20 kHz | N | < 20 Mµ |
| Square | 140 | 200 kHz | N | < 20 Mµ |
| Square | 70 | 20 kHz | N | < 20 Mµ |
| Square | 100 | 10 kHz | Y, low | < 20 Mµ |
| Square | 100 | 1 kHz | Y, medium | < 20 Mµ |
| Square | 100 | 200 Hz | Y, high | < 20 Mµ |
| Square | 70 | 200 Hz | Y, medium | < 20 Mµ |
| Square | 70 | 1 kHz | Y, low | < 20 Mµ |
| Square | 70 | 200 Hz | N | > 100 Mµ |

As shown in Table 2, for the experimentation performed a square waveform was preferred, with frequency ranges from about 200 Hz to about 1 kHz, and an amplitude of a minimum of about 70 Volts. Such combination will ensure proper sensation for standard human. The results as well imply that the thickness plays a role and as the thickness increase so does the required input voltage.

Accordingly, the results show the development of sensitive triboelectric based actuator that induces a human sensation by an input of both amplitude and frequency modulated alternating power signal (e.g., voltage). Since square wave signal was preferred, the use of digital control of duty cycle with PWM (pulse width modulation) via corresponding power transistor logic can enable haptic pattern control for mimicking events, surfaces, etc.

### Example 2

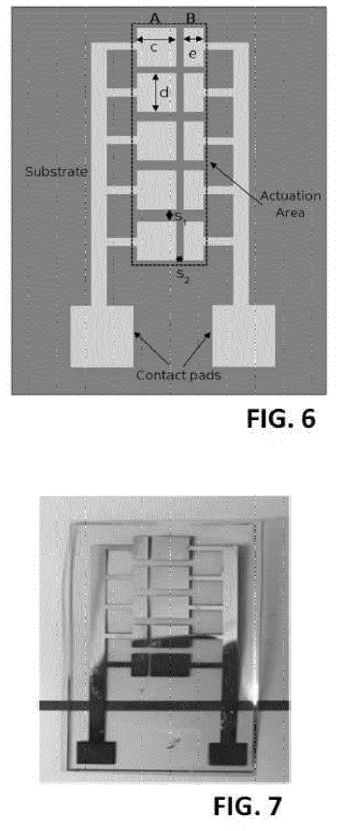

A second example device was fabricated with a triboelectric layer and a plurality of electrodes. Actuator Electrode Design was performed. Actuators having active area of (c x d) and (d x e) dimensions were designed using Tanner L-Edit software. The dimensions of c, d and e were 5, 5, and 2 mm, respectively. The separation (s1) between actuators of type-A was varied from 0.2 to 1.5 mm. The separation (s2) between type-A and type-B actuators was fixed as 0.5 mm, as shown in FIG. 6.

A plurality of electrodes were prepared. A bi-layer of titanium and gold electrodes were patterned on ULTEM 1000B plastic substrates using conventional photolithography techniques and electron-beam evaporation deposition. A 4 um-thick ECI3027 positive photoresist (PR) was first spin coated on the substrate. The PR layer was then exposed with a broadband UV light source at a dose of 200 mJ.cm⁻² and a photomask to transfer the desired features. The PR was then developed using AZ 726 MIF developer for 60 seconds. Titanium (30 nm) and gold (120 nm) electrodes were then deposited using e-beam evaporation deposition. Lift-off using acetone was performed to remove the unwanted areas and cleaned in isopropanol and DI water to complete the electrode patterning process.

The triboelectric layer was prepared. About 20 wt. % PVDF-TrFE was dissolved in Dimethylformamide. The PVDF-TrFE copolymer's composition was about 70% Polyvinyldieneflouride and about 30% Trifluoroethylene, while analytical grade of Dimethylformamide was used. Similarly, about 20 wt. % XPC-F-POSS was dissolved in Dimethylformamide. The XPC-F-POSS composition was about 85% XPC and about 15% FPOSS. The solutions were magnetically stirred at a temperature of about 50-60 °C until full dissolution was observed - usually takes 2-4 hours. Then, the solutions were spin coated on the electrode-coated substrates at a fixed spin speed of 1000 rpm. Finally, the samples were cured in a vacuum oven for 2 hours at 50-100°C.

The second example device was tested to determine performance. A waveform generator was used to set the frequency, waveform, and amplitude. The waveform generator was connected to a piezo driver to amplify the input AC voltage. FIG. 7 shows an optical image of a triboelectric based actuator comprising a plurality of electrodes (e.g., or actuator pads). Several designs could be implemented depending on the intended application. Each actuator pad can be connected separately and as such it can give more information on the location and surface morphology.

Measurements showed that a square waveform, with a minimum frequency of 100 Hz, and an amplitude of 60 Volts are proper set of parameters to ensure reasonable human sensation. There was also a minimum distance between the triboelectric pads to induce proper sensation. For example, with a distance of about 10, about 20, and about 30 microns, the sensation was not differentiated and appears to be only one pad. On the other hand, a distance of about 0.5 and about 1.5 mm appears to induce proper human sensation of an array of actuators.

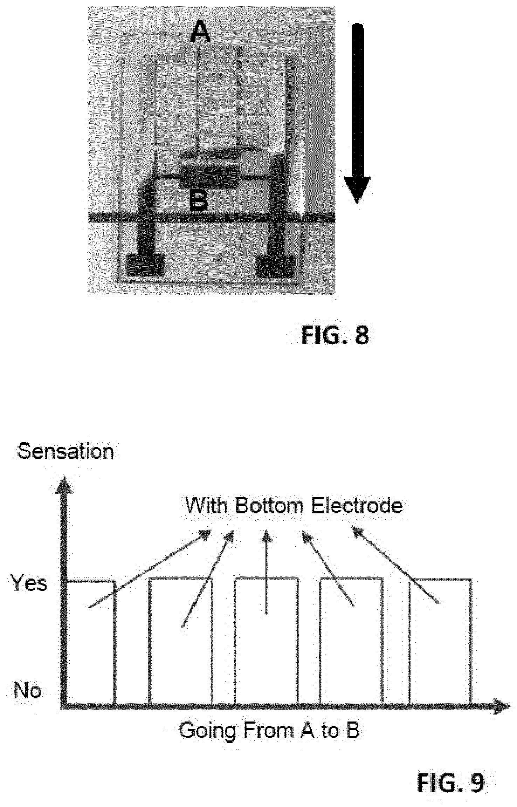

FIG. 8 shows an optical image of a triboelectric device for illustrating generating a sensation of movement along the device. A direction of sliding a finger through the surface of the triboelectric film with underlying powered electrodes (e.g., having an applied signal) area from the point A to B is shown. FIG. 9 is a graph showing generation of a sensation of movement along the device. The graph represents human perception of that applied alternating signal in specific areas of the underlying electrodes.

The results show that the disclosed device can be implemented as an array of actuators to simulate the touch, location, and surface topography by simulating sensation of finger's nerves through an electric input of alternating voltage, a surface made of a triboelectric material, and a patterned conductive layer.

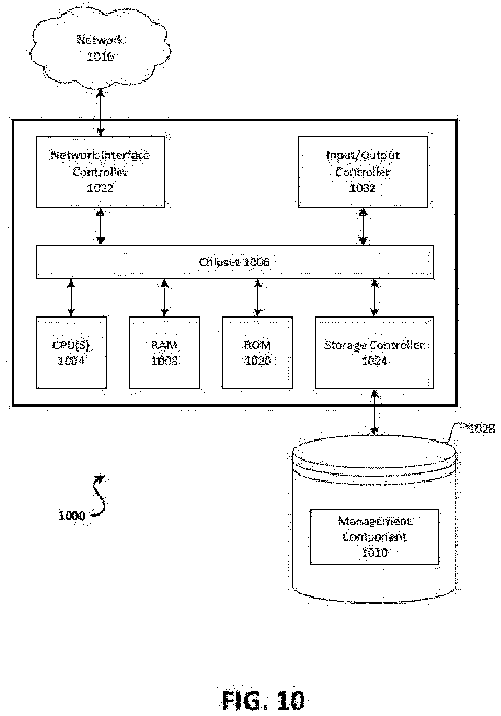

FIG. 10 depicts a computing device that can be used in various aspects, such as the devices and systems depicted throughout the disclosure. With regard to the example architecture of FIG. 1, the device 100 can each be implemented in an instance of a computing device 1000 of FIG. 10. The computer architecture shown in FIG. 10 shows a conventional server computer, workstation, desktop computer, laptop, tablet, network appliance, PDA, e-reader, digital cellular phone, or other computing node and peripherals, and can be utilized to execute any aspects of the computers described herein, such as to implement the methods described throughout the disclosure. As an example, the device 100 can determine data (e.g., instructions, conditions, sensor data, touch events). The device 100 can send the data to another device via network 1016. The other device can be a computing device of service, such as a cloud data service. The data can be accessed via the service by users in different locations (e.g., external to a premises or location of the device 100). The device 100 can receive data via the network 1016. The data can comprise an instruction for causing actuation of the device 100. The data can be used to cause one or more signals to be generated and supplied to a triboelectric layer to provide a sensation, tactile perception (e.g., for haptic feedback or other quality).

The computing device 1000 can include a baseboard, or "motherboard," which is a printed circuit board to which a multitude of components or devices can be connected by way of a system bus or other electrical communication paths. One or more central processing units (CPUs) 1004, or microcontrollers (MCUs) can operate in conjunction with a chipset 1006. The CPU(s) 1004 can be standard programmable processors that perform arithmetic and logical operations necessary for the operation of the computing device 1000.

The CPU(s) 1004 can perform the necessary operations by transitioning from one discrete physical state to the next through the manipulation of switching elements that differentiate between and change these states. Switching elements can generally include electronic circuits that maintain one of two binary states, such as flip-flops, and electronic circuits that provide an output state based on the logical combination of the states of one or more other switching elements, such as logic gates. These basic switching elements can be combined to create more complex logic circuits including registers, adders-subtractors, arithmetic logic units, floating-point units, and the like.

The CPU(s) 1004 can be augmented with or replaced by other processing units, such as graphics processing unit or GPU(s) 1005. The GPU(s) 1005 can comprise processing units specialized for but not necessarily limited to highly parallel computations, such as graphics, other visualization-related processing, simple instruction sets, a combination thereof, and/or the like.

A chipset 1006 can provide an interface between the CPU(s) 1004 and the remainder of the components and devices on the baseboard. The chipset 1006 can provide an interface to a random access memory (RAM) 1008 used as the main memory in the computing device 1000. The chipset 1006 can further provide an interface to a computer-readable storage medium, such as a read-only memory (ROM) 1020 or non-volatile RAM (NVRAM) (not shown), for storing basic routines that can help to start up the computing device 1000 and to transfer information between the various components and devices. ROM 1020 or NVRAM can also store other software components necessary for the operation of the computing device 1000 in accordance with the aspects described herein.

The computing device 1000 can operate in a networked environment using logical connections to remote computing nodes and computer systems through local area network (LAN) 1016. The chipset 1006 can include functionality for providing network connectivity through a network interface controller (NIC) 1022, such as a gigabit Ethernet adapter. A NIC 1022 can be capable of connecting the computing device 1000 to other computing nodes over a network 1016. It should be appreciated that multiple NICs 1022 can be present in the computing device 1000, connecting the computing device to other types of networks and remote computer systems.

The computing device 1000 can be connected to a mass storage device 1028 that provides non-volatile storage for the computer. The mass storage device 1028 can store system programs, application programs, other program modules, and data, which have been described in greater detail herein. The mass storage device 1028 can be connected to the computing device 1000 through a storage controller 1024 connected to the chipset 1006. The mass storage device 1028 can consist of one or more physical storage units. A storage controller 1024 can interface with the physical storage units through a serial attached SCSI (SAS) interface, a serial advanced technology attachment (SATA) interface, a fiber channel (FC) interface, or other type of interface for physically connecting and transferring data between computers and physical storage units.

The computing device 1000 can store data on a mass storage device 1028 by transforming the physical state of the physical storage units to reflect the information being stored. The specific transformation of a physical state can depend on various factors and on different implementations of this description. Examples of such factors can include, but are not limited to, the technology used to implement the physical storage units and whether the mass storage device 1028 is characterized as primary or secondary storage and the like.

For example, the computing device 1000 can store information to the mass storage device 1028 by issuing instructions through a storage controller 1024 to alter the magnetic characteristics of a particular location within a magnetic disk drive unit, the reflective or refractive characteristics of a particular location in an optical storage unit, or the electrical characteristics of a particular capacitor, transistor, or other discrete component in a solid-state storage unit. Other transformations of physical media are possible without departing from the scope and spirit of the present description, with the foregoing examples provided only to facilitate this description. The computing device 1000 can further read information from the mass storage device 1028 by detecting the physical states or characteristics of one or more particular locations within the physical storage units.

In addition to the mass storage device 1028 described above, the computing device 1000 can have access to other computer-readable storage media to store and retrieve information, such as program modules, data structures, or other data. It should be appreciated by those skilled in the art that computer-readable storage media can be any available media that provides for the storage of non-transitory data and that can be accessed by the computing device 1000.

By way of example and not limitation, computer-readable storage media can include volatile and non-volatile, transitory computer-readable storage media and non-transitory computer-readable storage media, and removable and non-removable media implemented in any method or technology. Computer-readable storage media includes, but is not limited to, RAM, ROM, erasable programmable ROM ("EPROM"), electrically erasable programmable ROM ("EEPROM"), flash memory or other solid-state memory technology, compact disc ROM ("CD-ROM"), digital versatile disk ("DVD"), high definition DVD ("HD-DVD"), BLU-RAY, or other optical storage, magnetic cassettes, magnetic tape, magnetic disk storage, other magnetic storage devices, or any other medium that can be used to store the desired information in a non-transitory fashion.

A mass storage device, such as the mass storage device 1028 depicted in FIG. 10, can store an operating system utilized to control the operation of the computing device 1000. The operating system can comprise a version of the LINUX operating system. The operating system can comprise a version of the WINDOWS SERVER operating system from the MICROSOFT Corporation. According to further aspects, the operating system can comprise a version of the UNIX operating system. Various mobile phone operating systems, such as IOS and ANDROID, can also be utilized. It should be appreciated that other operating systems can also be utilized. The mass storage device 1028 can store other system or application programs and data utilized by the computing device 1000.

The mass storage device 1028 or other computer-readable storage media can also be encoded with computer-executable instructions, which, if loaded into the computing device 1000, transforms the computing device from a general-purpose computing system into a special-purpose computer capable of implementing the aspects described herein. These computer-executable instructions transform the computing device 1000 by specifying how the CPU(s) 1004 transition between states, as described above. The computing device 1000 can have access to computer-readable storage media storing computer-executable instructions, which, if executed by the computing device 1000, can perform the methods described throughout the disclosure.

A computing device, such as the computing device 1000 depicted in FIG. 10, can also include an input/output controller 1032 for receiving and processing input from a number of input devices, such as a keyboard, a mouse, a touchpad, a touch screen, an electronic stylus, or other type of input device. Similarly, an input/output controller 1032 can provide output to a display, such as a computer monitor, a flat-panel display, a digital projector, a printer, a plotter, or other type of output device. It will be appreciated that the computing device 1000 may not include all of the components shown in FIG. 10, can include other components that are not explicitly shown in FIG. 10, or can utilize an architecture completely different than that shown in FIG. 10.

As described herein, a computing device can be a physical computing device, such as the computing device 1000 of FIG. 10. A computing node can also include a virtual machine host process and one or more virtual machine instances. Computer-executable instructions can be executed by the physical hardware of a computing device indirectly through interpretation and/or execution of instructions stored and executed in the context of a virtual machine.

It is to be understood that the methods and systems are not limited to specific methods, specific components, or to particular implementations. It is also to be understood that the terminology used herein is for the purpose of describing particular embodiments only and is not intended to be limiting.

Components are described that can be used to perform the described methods and systems. When combinations, subsets, interactions, groups, etc., of these components are described, it is understood that while specific references to each of the various individual and collective combinations and permutations of these may not be explicitly described, each is specifically contemplated and described herein, for all methods and systems. This applies to all aspects of this application including, but not limited to, operations in described methods. Thus, if there are a variety of additional operations that can be performed it is understood that each of these additional operations can be performed with any specific embodiment or combination of embodiments of the described methods.

As will be appreciated by one skilled in the art, the methods and systems can take the form of an entirely hardware embodiment, an entirely software embodiment, or an embodiment combining software and hardware aspects. Furthermore, the methods and systems can take the form of a computer program product on a computer-readable storage medium having computer-readable program instructions (e.g., computer software) embodied in the storage medium. More particularly, the present methods and systems can take the form of web-implemented computer software. Any suitable computer-readable storage medium can be utilized including hard disks, CD-ROMs, optical storage devices, or magnetic storage devices.

Embodiments of the methods and systems are described herein with reference to block diagrams and flowchart illustrations of methods, systems, apparatuses and computer program products. It will be understood that each block of the block diagrams and flowchart illustrations, and combinations of blocks in the block diagrams and flowchart illustrations, respectively, can be implemented by computer program instructions. These computer program instructions can be loaded on a general-purpose computer, special-purpose computer, or other programmable data processing apparatus to produce a machine, such that the instructions which execute on the computer or other programmable data processing apparatus create a means for implementing the functions specified in the flowchart block or blocks.

These computer program instructions can also be stored in a computer-readable memory that can direct a computer or other programmable data processing apparatus to function in a particular manner, such that the instructions stored in the computer-readable memory produce an article of manufacture including computer-readable instructions for implementing the function specified in the flowchart block or blocks. The computer program instructions can also be loaded onto a computer or other programmable data processing apparatus to cause a series of operational steps to be performed on the computer or other programmable apparatus to produce a computer-implemented process such that the instructions that execute on the computer or other programmable apparatus provide steps for implementing the functions specified in the flowchart block or blocks.

The various features and processes described above can be used independently of one another, or can be combined in various ways. All possible combinations and sub-combinations are intended to fall within the scope of this disclosure. In addition, certain methods or process blocks can be omitted in some implementations. The methods and processes described herein are also not limited to any particular sequence, and the blocks or states relating thereto can be performed in other sequences that are appropriate. For example, described blocks or states can be performed in an order other than that specifically described, or multiple blocks or states can be combined in a single block or state. The example blocks or states can be performed in serial, in parallel, or in some other manner. Blocks or states can be added to or removed from the described example embodiments. The example systems and components described herein can be configured differently than described. For example, elements can be added to, removed from, or rearranged compared to the described example embodiments.

It will also be appreciated that various items are illustrated as being stored in memory or on storage while being used, and that these items or portions thereof can be transferred between memory and other storage devices for purposes of memory management and data integrity. Alternatively, in other embodiments, some or all of the software modules and/or systems can execute in memory on another device and communicate with the illustrated computing systems via inter-computer communication. Furthermore, in some embodiments, some or all of the systems and/or modules can be implemented or provided in other ways, such as at least partially in firmware and/or hardware, including, but not limited to, one or more application-specific integrated circuits ("ASICs"), standard integrated circuits, controllers (e.g., by executing appropriate instructions, and including microcontrollers and/or embedded controllers), field-programmable gate arrays ("FPGAs"), complex programmable logic devices ("CPLDs"), etc. Some or all of the modules, systems, and data structures can also be stored (e.g., as software instructions or structured data) on a computer-readable medium, such as a hard disk, a memory, a network, or a portable media article to be read by an appropriate device or via an appropriate connection. The systems, modules, and data structures can also be transmitted as generated data signals (e.g., as part of a carrier wave or other analog or digital propagated signal) on a variety of computer-readable transmission media, including wireless-based and wired/cable-based media, and can take a variety of forms (e.g., as part of a single or multiplexed analog signal, or as multiple discrete digital packets or frames). Such computer program products can also take other forms in other embodiments. Accordingly, the present invention can be practiced with other computer system configurations.

The present disclosure can comprise at the least the following aspects.
Aspect 1. A device comprising, consisting of, or consisting essentially of: an electrode; a triboelectric layer disposed adjacent the electrode; and a signal source (e.g., voltage source, signal generator, current source) electrically coupled to the electrode and configured to supply a signal to the electrode to cause a change in an electrostatic potential of the triboelectric layer. The change in the electrostatic potential can cause a perceivable sensation to an object (e.g., human, animal, skin, appendage, body, finger, nerve) in contact with the triboelectric layer. The change in the electrostatic potential can change according to one or more parameters, such as frequency, amplitude, wave shape, and/or other feature (e.g., due to the signal). The change in electrostatic potential can change (e.g., according to the one or more parameters) such that the change is a perceivable sensation (e.g., to skin, to a nerve). The parameters can depend on the thickness, size, and/or shape of the triboelectric layer. The amplitude may be about 70 V. The thickness may be in a range of about 60 V to about 140 V. The frequency may be in a range of one or more of about 1 Hz to 1 kHz, about 200 Hz to about 1 kHz, about 5 Hz to about 1 kHz, or about 1 Hz to about 10 kHz. As an example, the one or more parameters can comprise one or more of about 70 V (e.g., or at least about 70V), about 10mA (e.g., or at least about 10mA), about 7W (e.g., or at least about 7W), about 5 Hz (e.g., or at least about 5 Hz), or a sine wave shape (e.g., or at least a partially sinusoidal wave shape). The perceivable sensation can comprise a tactile sensation. The perceivable sensation can be perceivable to a human or animal. The perceivable sensation can comprise a haptic feedback, sensation of a texture, sensation of movement (e.g., along a path, along the object), a combination thereof, and/or the like.
Aspect 2. The device of aspect 1, wherein the triboelectric layer comprises a photoactive polycarbonate thermoplastic material and isofluoropropyl polyhedral oligomeric silsesquioxane.
Aspect 3. The device of any one of aspects 1-2, further comprising an additional triboelectric layer disposed adjacent the triboelectric layer.
Aspect 4. The device of any one of aspects 1-3, wherein the signal causes a tactile sensation upon touching the triboelectric layer.
Aspect 5. The device of any one of aspects 1-4, wherein the signal is configured to repel particles from the triboelectric layer or attract particles to the triboelectric layer.
Aspect 6. The device of any one of aspects 1-5, further comprising one or more additional electrodes disposed adjacent the triboelectric layer.
Aspect 7. The device of aspect 6, wherein the one or more additional electrodes are arranged as a pattern of electrodes.
Aspect 8. The device of any one of aspects 6-7, wherein the signal source is configured to supply a plurality of different signals to at least a portion of the one or more additional electrodes.
Aspect 9. The device of aspect 8, wherein the plurality of different signals are configured to cause a sensation of a texture upon touching the triboelectric layer.
Aspect 10. The device of any one of aspects 1-9, wherein the signal is one or more of amplitude modulated or frequency modulated to cause a variation in the electrostatic potential.
Aspect 11. The device of any one of aspects 1-10, wherein the signal is modified based on a sensor signal.
Aspect 12. The device of any one of aspects 1-11, further comprising a processing unit configured to cause the signal source to supply the signal.
Aspect 13. A method comprising, consisting of, or consisting essentially of: receiving data; and supplying, based on the data, a signal to an electrode disposed adjacent to a triboelectric layer to cause a change in an electrostatic potential of the triboelectric layer. The change in the electrostatic potential can cause a perceivable sensation to an object in contact with the triboelectric layer. The change in the electrostatic potential can change according to one or more parameters, such as frequency, amplitude, wave shape, and/or other feature (e.g., due to the signal). The change in electrostatic potential can change (e.g., according to the one or more parameters) such that the change is a perceivable sensation (e.g., to skin, to a nerve). The parameters can depend on the thickness, size, and/or shape of the triboelectric layer. The amplitude may be about 70 V. The thickness may be in a range of about 60 V to about 140 V. The frequency may be in a range of one or more of about 1 Hz to 1 kHz, about 200 Hz to about 1 kHz, about 5 Hz to about 1 kHz, or about 1 Hz to about 10 kHz. As an example, the one or more parameters can comprise one or more of about 70 V (e.g., or at least about 70V), about 10mA (e.g., or at least about 10mA), about 7W (e.g., or at least about 7W), about 5 Hz (e.g., or at least about 5 Hz), or a sine wave shape (e.g., or at least a partially sinusoidal wave shape). The perceivable sensation can comprise a tactile sensation. The perceivable sensation can be perceivable to a human or animal. The perceivable sensation can comprise a haptic feedback, sensation of a texture, sensation of movement, a combination thereof, and/or the like.
Aspect 14. The method of aspect 13, wherein supplying the signal comprising supplying an amplitude modulated signal or frequency modulated signal to cause a variation in the electrostatic potential.
Aspect 15. The method of any one of aspects 13-14, wherein supplying the signal causes one or more of: a tactile sensation in the triboelectric layer upon touching the triboelectric layer, repelling of particles from the triboelectric layer, or attracting of particles to the triboelectric layer.
Aspect 16. The method of any one of aspects 13-15, wherein the triboelectric layer comprises a photoactive polycarbonate thermoplastic material and isofluoropropyl polyhedral oligomeric silsesquioxane.
Aspect 17. The method of any one of aspects 13-16, wherein receiving data comprises receiving sensor data.
Aspect 18. The method of any one of aspects 13-17, wherein receiving sensor data comprises receiving the sensor data from one or more of the triboelectric layer or an additional triboelectric layer.
Aspect 19. The method of any one of aspects 13-18, wherein the signal causes a tactile sensation upon touching the triboelectric layer.
Aspect 20. The method of any one of aspects 13-19, wherein the signal is configured to repel particles from the triboelectric layer or attract particles to the triboelectric layer.
Aspect 21. The method of any one of aspects 13-20, wherein supplying the signal to the electrode disposed adjacent to the triboelectric layer comprises supplying the signal to one or more additional electrodes disposed adjacent the triboelectric layer.
Aspect 22. The method of aspect 21, wherein the one or more additional electrodes are arranged as a pattern of electrodes.
Aspect 23. The method of any one of aspects 21-22, wherein supplying the signal to one or more additional electrodes disposed adjacent the triboelectric layer comprises supplying a plurality of different signals to at least a portion of the one or more additional electrodes.
Aspect 24. The method of aspect 23, wherein the plurality of different signals are configured to cause a sensation of a texture upon touching the triboelectric layer.
Aspect 25. A system comprising, consisting of, or consisting essentially of: at least one triboelectric layer; a plurality of electrodes disposed adjacent corresponding portions for the at least one triboelectric layer; and one or more processors electrically coupled to the plurality of electrodes and configured to cause changes in an electrostatic potential of the at least one triboelectric layer by causing one or more signals to be supplied to one or more of the plurality of electrodes. The changes in the electrostatic potential can cause a perceivable sensation to an object in contact with the triboelectric layer. The change in the electrostatic potential can change according to one or more parameters, such as frequency, amplitude, wave shape, and/or other feature (e.g., due to the signal). The change in electrostatic potential can change (e.g., according to the one or more parameters) such that the change is a perceivable sensation (e.g., to skin, to a nerve). The parameters can depend on the thickness, size, and/or shape of the triboelectric layer. The amplitude may be about 70 V. The thickness may be in a range of about 60 V to about 140 V. The frequency may be in a range of one or more of about 1 Hz to 1 kHz, about 200 Hz to about 1 kHz, about 5 Hz to about 1 kHz, or about 1 Hz to about 10 kHz. As an example, the one or more parameters can comprise one or more of about 70 V (e.g., or at least about 70V), about 10mA (e.g., or at least about 10mA), about 7W (e.g., or at least about 7W), about 5 Hz (e.g., or at least about 5 Hz), or a sine wave shape (e.g., or at least a partially sinusoidal wave shape). The perceivable sensation can comprise a tactile sensation. The perceivable sensation can be perceivable to a human or animal. The perceivable sensation can comprise a haptic feedback, sensation of a texture, sensation of movement, a combination thereof, and/or the like.
Aspect 26. The system of aspect 25, wherein the at least one triboelectric layer comprises a photoactive polycarbonate thermoplastic material and isofluoropropyl polyhedral oligomeric silsesquioxane.
Aspect 27. The system of any one of aspects 25-26, further comprising an additional triboelectric layer disposed adjacent the triboelectric layer.
Aspect 28. The system of any one of aspects 25-27, wherein the signal causes a tactile sensation upon touching the at least one triboelectric layer.
Aspect 29. The system of any one of aspects 25-28, wherein the signal is configured to repel particles from the at least one triboelectric layer or attract particles to the at least one triboelectric layer.
Aspect 30. The system of any one of aspects 25-29, wherein the plurality of electrodes are arranged as a pattern of electrodes.
Aspect 31. The system of aspect 30, wherein the pattern of electrodes comprises pairs of electrodes arranged according to the pattern.
Aspect 32. The system of any one of aspects 25-31, further comprising a signal source controlled by the one or more processors and configured to supply a plurality of different signals to at least a portion of the plurality of electrodes.
Aspect 33. The system of any one of aspects 25-32, wherein the one or more signals cause a sensation of a texture upon touching the triboelectric layer.
Aspect 34. The system of any one of aspects 25-33, wherein the one or more signals are one or more of amplitude modulated or frequency modulated to cause a variation in the electrostatic potential.
Aspect 35. The system of any one of aspects 25-34, wherein the one or more signals are modified based on a sensor signal.
Aspect 36. A non-transitory computer-readable medium storing instructions that, when executed by one or more processors, cause a device to perform the methods of any one of aspects 13-24.
Aspect 37. A device comprising: an electrode; and a triboelectric layer disposed adjacent the electrode, wherein the triboelectric layer is configured to receive, from a signal source and via the electrode, a signal to cause a change in an electrostatic potential of the triboelectric layer. The change in the electrostatic potential can cause a perceivable sensation to an object in contact with the triboelectric layer. The change in the electrostatic potential can change according to one or more parameters, such as frequency, amplitude, wave shape, and/or other feature (e.g., due to the signal). The change in electrostatic potential can change (e.g., according to the one or more parameters) such that the change is a perceivable sensation (e.g., to skin, to a nerve). The parameters can depend on the thickness, size, and/or shape of the triboelectric layer. The amplitude may be about 70 V. The thickness may be in a range of about 60 V to about 140 V. The frequency may be in a range of one or more of about 1 Hz to 1 kHz, about 200 Hz to about 1 kHz, about 5 Hz to about 1 kHz, or about 1 Hz to about 10 kHz. As an example, the one or more parameters can comprise one or more of about 70 V (e.g., or at least about 70V), about 10mA (e.g., or at least about 10mA), about 7W (e.g., or at least about 7W), about 5 Hz (e.g., or at least about 5 Hz), or a sine wave shape (e.g., or at least a partially sinusoidal wave shape). The perceivable sensation can comprise a tactile sensation. The perceivable sensation can be perceivable to a human or animal. The perceivable sensation can comprise a haptic feedback, sensation of a texture, sensation of movement, a combination thereof, and/or the like.
Aspect 38. The device of aspect 37, wherein the triboelectric layer comprises a photoactive polycarbonate thermoplastic material and isofluoropropyl polyhedral oligomeric silsesquioxane.
Aspect 39. The device of any one of aspects 37-38, further comprising an additional triboelectric layer disposed adjacent the triboelectric layer.
Aspect 40. The device of any one of aspects 37-39, wherein the signal causes a tactile sensation upon touching the triboelectric layer.
Aspect 41. The device of any one of aspects 37-40, wherein the signal is configured to repel particles from the triboelectric layer or attract particles to the triboelectric layer.
Aspect 42. The device of any one of aspects 37-41, further comprising one or more additional electrodes disposed adjacent the triboelectric layer.
Aspect 43. The device of aspect 42, wherein the one or more additional electrodes are arranged as a pattern of electrodes.
Aspect 44. The device of any one of aspects 42-43, wherein the signal source is configured to supply a plurality of different signals to at least a portion of the one or more additional electrodes.
Aspect 45. The device of aspect 44, wherein the plurality of different signals are configured to cause a sensation of a texture upon touching the triboelectric layer.
Aspect 46. The device of any one of aspects 37-45, wherein the signal is one or more of amplitude modulated or frequency modulated to cause a variation in the electrostatic potential.
Aspect 47. The device of any one of aspects 37-46, wherein the signal is modified based on a sensor signal.
Aspect 48. The device of any one of aspects 37-47, further comprising one or more of the signal source or a processing unit (e.g., or controller, microcontroller, digital signal controller) configured to cause the signal source to supply the signal.

### Definitions

It is also to be understood that the terminology used herein is for the purpose of describing particular aspects only and is not intended to be limiting.

Throughout the description and claims of this specification, the word "comprise" and variations of the word, such as "comprising" and "comprises," means "including but not limited to," and is not intended to exclude, for example, other components, integers or steps. The term "comprising" can include the embodiments "consisting of' and "consisting essentially of." "Exemplary" means "an example of' and is not intended to convey an indication of a preferred or ideal embodiment. "Such as" is not used in a restrictive sense, but for explanatory purposes.

Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated ±10% variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

As used herein, the terms "optional" or "optionally" means that the subsequently described event or circumstance can or cannot occur, and that the description includes instances where said event or circumstance occurs and instances where it does not. For example, the phrase "optional additional additives" means that the additional additives can or cannot be included and that the description includes compositions that both include and do not include additional additives.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included. As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Unless otherwise stated to the contrary herein, all test standards are the most recent standard in effect at the time of filing this application. Each of the materials disclosed herein are either commercially available and/or the methods for the production thereof are known to those of skill in the art. It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

Throughout this document, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise. The term "about" as used herein can allow for a degree of variability in a value or range, for example, within 10%, within 5%, or within 1% of a stated value or of a stated limit of a range, and includes the exact stated value or range. The term "substantially" as used herein refers to a majority of, or mostly, as in at least about 50%, 60%, 70%, 80%, 90%, 95%, 96%, 97%, 98%, 99%, 99.5%, 99.9%, 99.99%, or at least about 99.999% or more, or 100%. While "about" permits some tolerance, a person of ordinary skill in the art would read the specification in light of his knowledge and skill for guidance on the level of that tolerance, and be reasonably apprised to a reasonable degree the metes and bounds of the claims.

In this document, the terms "a," "an," or "the" are used to include one or more than one unless the context clearly dictates otherwise. The term "or" is used to refer to a nonexclusive "or" unless otherwise indicated. The statement "at least one of A and B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading can occur within or outside of that particular section.

In the methods described herein, the acts can be carried out in any order without departing from the principles of the invention, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

The term "radiation" as used herein refers to energetic particles travelling through a medium or space. Examples of radiation are visible light, infrared light, microwaves, radio waves, very low frequency waves, extremely low frequency waves, thermal radiation (heat), and black-body radiation. The term "UV light" as used herein refers to ultraviolet light, which is electromagnetic radiation with a wavelength of about 10 nm to about 400 nm.

The term "cure" as used herein refers to exposing to radiation in any form, heating, or allowing to undergo a physical or chemical reaction that results in hardening or an increase in viscosity.

The term "coating" as used herein refers to a continuous or discontinuous layer of material on the coated surface, wherein the layer of material can penetrate the surface and can fill areas such as pores, wherein the layer of material can have any three-dimensional shape, including a flat or curved plane. In one example, a coating can be applied to one or more surfaces, any of which can be porous or nonporous, by immersion in a bath of coating material.

The term "surface" as used herein refers to a boundary or side of an object, wherein the boundary or side can have any perimeter shape and can have any three-dimensional shape, including flat, curved, or angular, wherein the boundary or side can be continuous or discontinuous. While the term surface generally refers to the outermost boundary of an object with no implied depth, when the term 'pores' is used in reference to a surface, it refers to both the surface opening and the depth to which the pores extend beneath the surface into the substrate.

As used herein, the term "polymer" refers to a molecule having at least one repeating unit and can include copolymers and homopolymers. The polymers described herein can terminate in any suitable way. In some embodiments, the polymers can terminate with an end group that is independently chosen from a suitable polymerization initiator, -H, -OH, a substituted or unsubstituted (C₁-C₂₀)hydrocarbyl (e.g., (C₁-C₁₀)alkyl or (C₆-C₂₀)aryl) interrupted with 0, 1, 2, or 3 groups independently selected from -O-, substituted or unsubstituted -NH-, and -S-, a poly(substituted or unsubstituted (C₁-C₂₀)hydrocarbyloxy), and a poly(substituted or unsubstituted (C₁-C₂₀)hydrocarbylamino).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code can form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

All publications mentioned herein are incorporated herein by reference to disclose and describe the methods and/or materials in connection with which the publications are cited. The above description is intended to be illustrative, and not restrictive. For example, the above-described examples (or one or more aspects thereof) can be used in combination with each other. Other embodiments can be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features can be grouped together to streamline the disclosure. This should not be interpreted as intending that an unclaimed disclosed feature is essential to any claim. Rather, inventive subject matter can lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A system comprising:
an electrode;
a triboelectric layer coupled to the electrode; and
a signal source electrically coupled to the electrode and configured to supply a signal to the electrode to cause a change in an electrostatic potential of the triboelectric layer, wherein the change in the electrostatic potential causes a perceivable sensation to an object in contact with the triboelectric layer.

2. The device of claim 1, wherein the triboelectric layer comprises a photoactive polycarbonate thermoplastic material and isofluoropropyl polyhedral oligomeric silsesquioxane.

3. The device of any one of claims 1-2, further comprising an additional triboelectric layer disposed adjacent the triboelectric layer.

4. The device of any one of claims 1-3, wherein the perceivable sensation comprises a tactile sensation.

5. The device of any one of claims 1-4, wherein the perceivable sensation comprises a sensation of movement along the object.

6. The device of any one of claims 1-5, further comprising one or more additional electrodes disposed adjacent the triboelectric layer.

7. The device of claim 6, wherein the one or more additional electrodes are arranged as a pattern of electrodes.

8. The device of any one of claims 6-7, wherein the signal source is configured to supply a plurality of different signals to at least a portion of the one or more additional electrodes.

9. The device of claim 8, wherein the plurality of different signals are configured to cause a sensation of a texture upon touching the triboelectric layer.

10. The device of any one of claims 1-9, wherein the signal is one or more of amplitude modulated or frequency modulated to cause a variation in the electrostatic potential.

11. The device of any one of claims 1-10, wherein the signal is modified based on a sensor signal.

12. The device of any one of claims 1-11, further comprising a processing unit configured to cause the signal source to supply the signal.

13. A method comprising:
receiving data; and
supplying, based on the data, a signal to an electrode disposed adjacent to a triboelectric layer to cause a change in an electrostatic potential of the triboelectric layer, wherein the change in the electrostatic potential causes a perceivable sensation to an object in contact with the triboelectric layer.

14. The method of claim 13, wherein supplying the signal comprising supplying an amplitude modulated signal or frequency modulated signal to cause a variation in the electrostatic potential, and wherein perceivable sensation comprise a tactile sensation.

15. A system comprising:
at least one triboelectric layer;
a plurality of electrodes disposed adjacent corresponding portions for the at least one triboelectric layer; and
one or more processors electrically coupled to the plurality of electrodes and configured to cause changes in an electrostatic potential of the at least one triboelectric layer by causing one or more signals to be supplied to one or more of the plurality of electrodes wherein the change in the electrostatic potential causes a perceivable sensation to an object in contact with the triboelectric layer.
